# FASCICULE DE BREVET EUROPEEN

(11) **EP 1 943 530 B1**
(45) Date de publication et mention de la délivrance du brevet: **29.08.2018**
(21) Numéro de dépôt: 06808229.6
(22) Date de dépôt: 02.10.2006
(51) Int. Cl.: G01R 31/311

(54) **DISPOSITIF D'ANALYSE D'UN CIRCUIT INTEGRE**
EINRICHTUNG ZUM ANALYSIEREN EINER INTEGRIERTEN SCHALTUNG
DEVICE FOR ANALYZING AN INTEGRATED CIRCUIT

(30) Priorité: 30.09.2005 FR 0510038
(43) Date de publication de la demande: 16.07.2008
(73) Titulaire: Centre National d'Etudes Spatiales (C.N.E.S.), 75039 Paris Cedex 01 (FR)
(72) Inventeur: DESPLATS, Romain, F-31320 Castanet Tolosan (FR)
(74) Mandataire: Gaillarde, Frédéric F. Ch.
(86) Numéro de dépôt international: PCT/FR2006/002220
(87) Numéro de publication internationale: WO 2007/036649

(56) Documents cités:
- US-A- 5 940 545
- US-A1- 2003 098 692
- US-A1- 2004 103 353
- US-A1- 2005 030 051
- US-B1- 6 388 454
- US-B2- 6 859 031
- D. LEWIS, V. POUGET, T. BEAUCHÊNE, H. LAPUYADE, P. FOUILLAT, A. TOUBOUL, F. BEAUDOIN AND P. PERDU: "Front Side and Backside OBIT Mappings applied to Single Event Transient Testing" MICROELECTRONICS RELIABILITY, vol. 41, no. 9-10, octobre 2001 (2001-10), pages 1471-1476, XP002417885

## Description

La présente invention concerne un dispositif d'analyse d'un circuit intégré, du type comportant :
- au moins un moyen d'observation de la lumière émise par au moins une zone d'observation localisée du circuit du fait de la circulation du courant électrique dans cette zone,
- des moyens d'excitation du circuit.

Plusieurs méthodes d'observation peuvent être mises en oeuvre pour obtenir des informations caractéristiques de l'état d'un circuit intégré.

Les documents US 6 859 031 B2, US 2004/103353 A1, US 2005/030051 A1 et l'article de D.LEWIS et al., intitulé « Front side and backside OBIT Mappings applied to single event transient testing » publié dans Microelectronics reliability, vol. 41, n° 9-10, octobre 2001 décrivent de tels méthodes.

En particulier, le document US 6,859,031 décrit trois modes d'observation possibles, lesquels peuvent être mis en oeuvre alternativement sur un même circuit.

Une première méthode consiste à réaliser une image bidimensionnelle du circuit en émission de lumière. Pour ce faire, le circuit est placé dans l'obscurité. Une séquence de test est appliquée aux bornes du circuit pour l'exciter. Le courant électrique circulant dans le circuit produit de la lumière émise par le circuit en différents points où des phénomènes électriques ont lieu. Un capteur optique tel qu'une matrice de détecteurs à couplage de charge acquiert la lumière émise par le circuit lors de son fonctionnement.

Un objectif du microscope est interposé entre le circuit intégré et le capteur optique. Le capteur optique est placé dans le plan image du microscope.

Suivant une autre méthode, une photodiode est placée en regard d'une petite zone d'observation du circuit. Cette photodiode détecte des pics d'émission de lumière aux instants où les transistors présents dans la zone d'observation sont activés lors de l'application d'une séquence de test. Ainsi, pour la zone considérée, la méthode permet de déterminer l'évolution dans le temps des émissions de lumière. Le résultat obtenu est une courbe présentant des pics aux instants d'émission. Une telle méthode est dite « en émission de lumière résolue dans le temps » ("time resolved émission" en anglais). Cette méthode est décrite dans le brevet américain d'IBM US-5,940,545 en utilisant la technique PICA (Picosecond Imaging Circuit Analysis) pour un unique point PICA ou analyse PICA monopoint.Selon une troisième méthode couramment appelée observation par laser réfléchi, un faisceau laser est focalisé sur un point du circuit. Une diode de détection détermine l'intensité lumineuse de l'onde réfléchie au point sur lequel le faisceau laser est focalisé. Le faisceau laser balaye la surface du circuit pour permettre l'acquisition d'une matrice de valeurs depuis la diode de détection, chaque valeur correspondant à une position du faisceau laser sur ce circuit. A partir de cette matrice de valeurs, une image du circuit est reconstituée.

Le microscope PHEMOS-1000 commercialisé par la société HAMA-MATSU propose des moyens pour la mise en oeuvre alternative, sur un circuit intégré, de moyens d'observations par une méthode d'émission de lumière ou par une méthode laser réfléchi.

La commutation entre un mode d'observation et un autre s'effectue par mise en place d'un miroir permettant de dévier la lumière issue du circuit vers l'un ou l'autre des moyens d'observation.

Le dispositif d'analyse décrit précédemment permet la mise en oeuvre de plusieurs méthodes d'observation mais celles-ci doivent être mises en oeuvre successivement et aucun des dispositifs ne permet que ces méthodes d'observation soient mises en oeuvre de manière simultanée. L'utilisateur ne peut donc pas bénéficier simultanément des avantages des différentes méthodes d'observations.

L'invention a pour but de proposer un dispositif d'analyse permettant la mise en oeuvre simultanée d'une observation par émission de lumière et d'un laser sollicitant le circuit observé.

A cet effet, l'invention a pour objet un dispositif d'analyse du type précité défini selon la revendication 1.

Suivant des modes de réalisation, le dispositif comporte l'une ou plusieurs des caractéristiques suivantes :
- les moyens d'observation et les moyens d'application du faisceau laser comportent des moyens de guidage de la lumière émise par le circuit et des faisceaux laser émis et réfléchis suivant un même chemin optique au voisinage du circuit ;
- les moyens d'observation comportent une matrice de capteurs ;
- les capteurs sont choisis dans le groupe consistant en des capteurs d'imagerie visible ou infrarouge à couplage de charge (CCD), des capteurs à Arséniure de Gallium (InGaAs) ou des capteurs à Tellure de Mercure et Cadmium (MCT) ;
- les capteurs sont des capteurs à émission de lumière tridimensionnelle de type Analyse de Circuit par Imagerie Picoseconde (PICA) ;
- les moyens d'observation comportent un capteur monopoint de lumière en émission résolue dans le temps dit de type TRE (Time Resolved Emission) ou de type PICA monopoint (Single point PICA) ;
- les moyens de guidage de la lumière comportent au moins un miroir semi-réfléchissant disposé entre le circuit et les moyens d'observation suivant un chemin de transmission et entre la source laser et le circuit suivant un chemin de réflexion, le miroir semi-réfléchissant étant au moins partiellement transparent aux longueurs d'ondes émises par le circuit et réfléchissant pour la longueur d'onde du faisceau laser émis par la source laser ;
- les moyens d'observation de la lumière émise comportent au moins un premier et un deuxième capteurs, disposés respectivement en arrière d'un premier et d'un second miroirs semi-réfléchissants, et successivement dans cet ordre du circuit jusqu'à la source laser suivant le trajet du faisceau laser réfléchi, les premier et second miroirs semi-réfléchissants étant au moins partiellement transparents aux longueurs d'ondes émises par le circuit et réfléchissants pour la longueur d'onde du faisceau laser émis par la source laser, le premier miroir semi-réfléchissant étant seulement partiellement transparent aux longueurs d'ondes d'observation du deuxième capteur ; et
- le dispositif comporte une diode de mesure de l'intensité du faisceau laser réfléchi.

L'invention sera mieux comprise à la lecture de la description qui va suivre, donnée uniquement à titre d'exemple et faite en se référant aux dessins sur lesquels :
- la Figure 1 est une vue schématique d'un dispositif d'analyse selon un premier mode de réalisation de l'invention ;
- la Figure 2 est une courbe illustrant la caractéristique de réflexion du miroir semi-transparent disposé en regard du moyen d'observation par émission de lumière en fonction de la longueur d'ondes ;
- la Figure 3 est une vue identique à celle de la Figure 1 d'un autre mode de réalisation selon l'invention ;
- la Figure 4 est une vue identique à celles des Figures 1 et 3 d'encore un autre mode de réalisation selon l'invention ;
- la Figure 5 est une vue identique à celle de la Figure 2 du miroir semi-transparent du mode de réalisation de la Figure 4 placé en regard du moyen d'observation par émission de lumière ;
- la Figure 6 est une courbe identique à celle de la Figure 2 pour le miroir semi-transparent placé en regard du détecteur monopoint de lumière en émission résolue dans le temps.

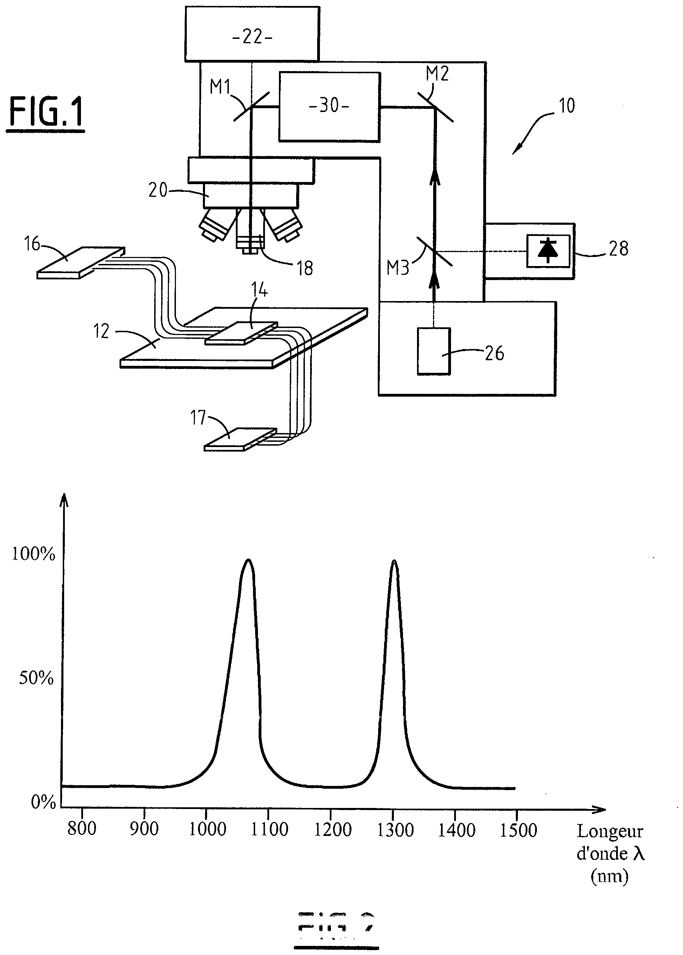

Le dispositif d'analyse 10 illustré sur la Figure 1 comporte une platine 12 de support d'un circuit intégré 14 devant être observé. Le dispositif comporte un testeur 16 propre à appliquer une séquence de tests aux bornes d'entrée du circuit intégré 14 comme connu en soi.

De même, ce testeur 16 comporte des moyens 17 de recueil des signaux électriques fournis en sortie du circuit intégré 14 en réponse à la séquence de test.

Au droit du circuit 14, le dispositif comporte un ou plusieurs objectifs 18 de microscope montés sur une tourelle rotative 20.

Du côté opposé au circuit par rapport à l'objectif, le dispositif comporte un premier miroir semi-réfléchissant M1 dont la face réfléchissante est tournée à 45° vers le circuit. En arrière du miroir M1 est disposé un dispositif 22 d'analyse en émission de lumière. Ce dispositif est placé en regard du circuit 14 suivant l'axe optique de l'objectif 18. Suivant un premier mode de réalisation, le dispositif 22 d'analyse en émission de lumière comporte comme connu en soi un capteur à coupleur de charge CCD.

En variante, il comporte un capteur de type MCT (Tellure de Mercure et Cadmium) permettant une détection en proche infra- rouge.

Suivant encore une variante, le dispositif 22 comporte un capteur de type PICA (Picosecond Imaging Circuit Analysis) pour l'analyse de circuit par imagerie picoseconde.

En regard du côté réfléchissant à 45° du miroir M1, est disposé un second miroir totalement réfléchissant M2 formant un renvoi d'angle.

Un troisième miroir semi-réfléchissant M3 est disposé à 45° en regard du miroir M2.

Une source laser 26 est disposée en arrière du miroir M3. Cette source est dirigée pour traverser le miroir M3. La source est suffisamment puissante pour que le faisceau focalisé en point du circuit 14 soit susceptible d'altérer le comportement d'un circuit. Suivant la longueur d'onde il est possible de générer un photo courant et / ou de générer un échauffement local. Ces perturbations peuvent modifier le courant parcourant le circuit et sont donc susceptibles d'être analysées par un moyen d'observation en émission de lumière.

Les miroirs M3, M2 et M1 sont disposés de sorte que le faisceau laser, après avoir traversé le miroir M3, soit réfléchi successivement sur les miroirs M2 et M1 jusqu'au circuit intégré 14 après avoir traversé l'objectif 18.

A l'inverse, l'agencement des miroirs M1, M2 et M3 successivement positionnés en regard les uns des autres est tel que le faisceau laser réfléchi sur le circuit 14 se propage successivement sur les miroirs M1, M2 et M3 par réflexions sur ceux-ci.

Avantageusement, deux sources laser interchangeables sont utilisées. Les lasers sont utilisés suivant le cas pour avoir soit un effet photoélectrique, soit un effet thermique.

Ces sources ont des longueurs d'ondes supérieures à 800nm et dans le proche infrarouge afin de passer à travers le silicium.

Le choix de 1064nm, proche de l'énergie de bandgap du silicium favorise la création de courants par photo-génération. La lumière sous forme de photons est convertie en porteurs (électrons et trous) qui sont séparés sous l'action d'un champ électrique.

Le choix de 1340nm est une longueur d'onde transparente au silicium avec prédominance des effets thermiques. Le laser vient par exemple chauffer les pistes en métalliques après avoir traversé le silicium.

Une diode 28 de détection de l'intensité lumineuse de l'onde laser réfléchie est disposée à 45° en regard du miroir M3 du côté de sa face réfléchissante.

Le miroir M3 est, par exemple, un miroir semi-réfléchissant polarisé propre à assurer une réflexion vers la diode 28 du faisceau laser réfléchi avec un déphasage par rapport au faisceau laser incident. Ainsi, le miroir M3 est tel que le faisceau laser incident est totalement transmis, alors que le faisceau laser réfléchi déphasé est totalement réfléchi vers la diode 28.

Comme cela est connu en soi, lors de la réflexion du faisceau laser sur le circuit 14, la phase de celui-ci est décalée de sorte qu'il est réfléchi par une lame polarisée elle-même décalée du même angle et formant le miroir M3.

Une unité 30 de déviation du faisceau laser incident émis par la source est disposée entre les miroirs M2 et M1 afin d'assurer un balayage du circuit intégré par déviation du faisceau laser incident. De même, cette unité est propre à assurer une déviation identique en retour du faisceau laser réfléchi.

Dans ce mode de réalisation, le miroir M1 est un miroir dichroïque dont la caractéristique de réflexion de la lumière en fonction du spectre en fréquence du faisceau incident est illustrée sur la Figure 2. Cette figure montre le pourcentage de lumière réfléchie en fonction de la longueur d'onde du faisceau.

Ce miroir présente deux pics de réflexion correspondant aux deux longueurs d'onde des sources laser 26 utilisées. Ainsi, l'un est centré sur la longueur d'onde de 1064nm alors que le second pic est centré sur la longueur d'onde de 1340nm.

Le dispositif de la Figure 1 s'utilise par exemple de la manière suivante.

Lors d'une phase initiale, une cartographie du circuit est effectuée à partir de la diode de détection 28. A cet effet, un faisceau laser est émis par la source 26 avec une puissance faible de l'ordre de 100 mW. Ce faisceau est déplacé à la surface du circuit 14 par l'unité de déviation 30 afin de balayer totalement le circuit. Le faisceau réfléchi par chaque point du circuit 14 est transmis jusqu'à la diode de détection 28 par réflexions successives sur les miroirs M1, M2 et M3. Le miroir M1 est réfléchissant compte tenu de la longueur d'onde particulière du laser et le miroir M3 est également réfléchissant du fait de sa polarisation.

Pour chaque position du circuit, une mesure est effectuée par la diode de détection 28. Comme connu en soi, une cartographie du circuit est obtenue à partir des mesures effectuées par la diode 28 pour chaque point d'impact du laser sur le circuit.

Dans une seconde phase, l'influence de l'application d'un faisceau laser de forte puissance sur un point particulier du circuit 14 est déterminée à partir d'une acquisition d'une image du circuit en émission de lumière.

A cet effet, un faisceau laser de forte puissance issu de la source 26 est focalisé après réflexion sur les miroirs M2 et M1 par les moyens de déviation 30 sur un point déterminé du circuit. Le laser est réglé à une plus forte puissance, par exemple égale à 300mW.

Suivant un premier mode de réalisation, le circuit 14 est soumis à une séquence de test. Une image du circuit en émission de lumière est acquise par le dispositif d'analyse 22. La lumière émise par le circuit résultant à la fois de la séquence de test appliquée et de l'excitation par le faisceau laser est transmise au travers de l'objectif 18 jusqu'au miroir M1, lequel est transparent pour toutes les longueurs d'onde à l'exception de celle immédiatement voisine de la longueur d'onde du laser. Ainsi, toutes les longueurs d'onde à l'exception de celle du laser sont transmises vers le dispositif 22 d'analyse en émission de lumière. Le faisceau laser est au contraire réfléchi sur les miroirs M1 et M2 et n'est donc pas transmis au dispositif d'analyse en émission de lumière 22, évitant ainsi de perturber les mesures effectuées par ce dispositif par éblouissement du détecteur, du fait de la puissance du laser.

L'image obtenue correspond à l'image moyenne du circuit sur la durée de la séquence de test lors de l'utilisation d'une matrice de capteurs CCD.

L'image ainsi obtenue peut être utilisée pour déterminer l'état de fonctionnement du circuit.

En variante, et de manière avantageuse, une seconde image du circuit soumis à la même séquence de test est acquise alors que le faisceau laser n'est plus appliqué sur le circuit. Une différence des deux images ainsi acquises est calculée. Cette image différentielle permet de mettre en évidence les seuls courants résultant du faisceau laser appliqué sur le circuit. Cette image permet de déceler d'éventuels dysfonctionnements dans le circuit.

Dans le cas de la variante du dispositif dans laquelle le capteur CCD sont remplacés par un capteur PICA, les images obtenues lors de la séquence de test sont un faisceau d'images correspondant chacune à un instant du test et non plus une image moyenne. Comme précédemment, un faisceau d'images différentiel est produit par différence du faisceau d'images acquis alors que le circuit est soumis localement au faisceau laser et un faisceau d'image en l'absence de faisceau laser.

Suivant une variante encore, aucune séquence de test n'est appliquée au circuit et celui-ci est seulement polarisé. Les mêmes étapes que précédemment sont alors mises en oeuvre.

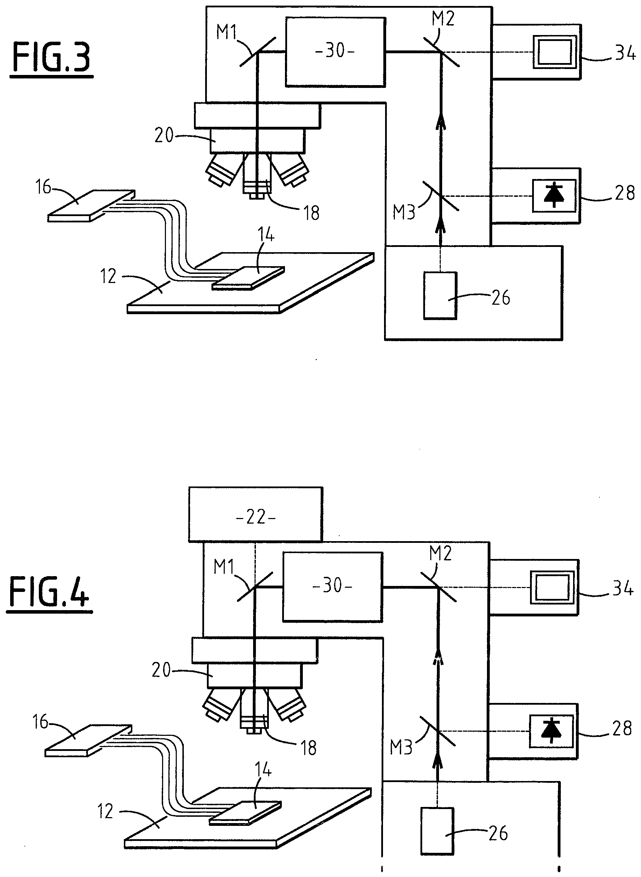

La figure 3 montre un autre mode de réalisation d'un dispositif selon l'invention.

Dans ce mode de réalisation, les éléments identiques ou correspondant à ceux du mode de réalisation précédent sont désignés par les mêmes numéros de référence.

Dans ce mode de réalisation, le miroir M1 est un miroir totalement réfléchissant et le dispositif 22 d'analyse en émission de lumière est supprimé. Au contraire, le miroir M2 présente les caractéristiques de réflexion illustrées sur la Figure 2. En arrière de ce miroir, suivant le trajet de la lumière émise par le circuit et réfléchie par le miroir M1, est disposé un détecteur monopoint 34 de lumière en émission résolue dans le temps.

Un tel capteur permet de déterminer au cours du temps l'évolution de la lumière émise par un point du circuit.

Lors de l'analyse du circuit, le faisceau laser émis par la source 26 est focalisé en un point du circuit 14, de préférence différent du point d'observation et une séquence de tests est appliquée au circuit. La courbe obtenue par le détecteur 34 et représentative du courant au cours du temps au point d'observation permet de déterminer d'éventuels dysfonctionnements du circuit.

Dans le mode de réalisation de la Figure 4, le dispositif comporte à la fois le dispositif 22 d'analyse en émission de lumière disposé en arrière du miroir M1 et le détecteur monopoint 34 de lumière en émission résolue dans le temps disposé en arrière du miroir M2.

Dans ce mode de réalisation, la longueur d'onde du laser produit par la source 26 est de préférence égale à 1340nm.

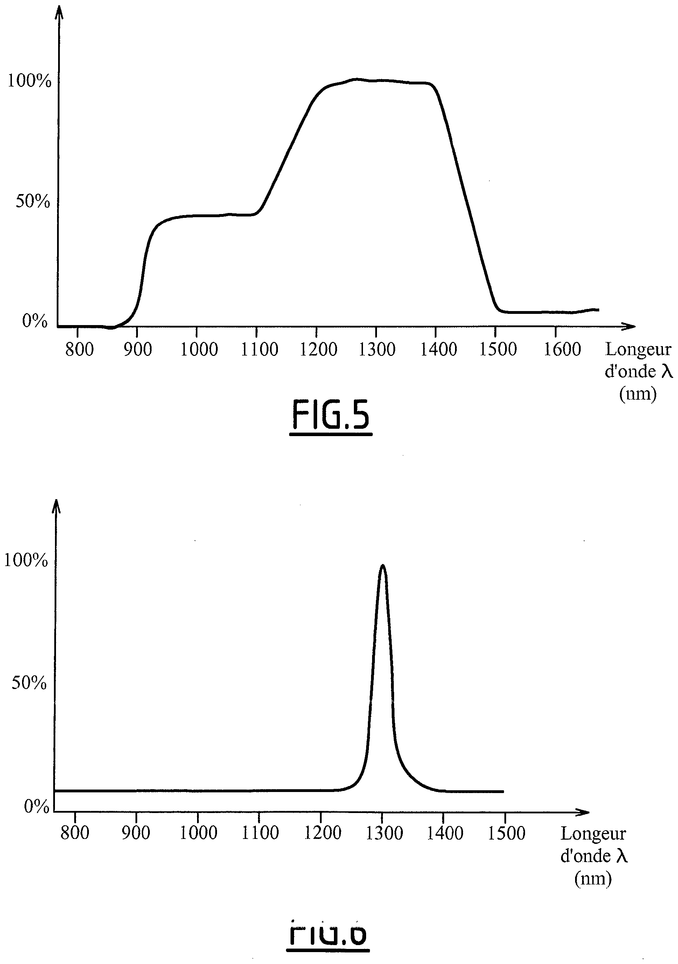

Dans un premier mode de réalisation et comme illustré sur la Figure 5, le miroir M1 est formé d'un miroir semi-réfléchissant assurant une transmission totale et une réflexion nulle pour les longueurs d'ondes inférieures à 900 nm. Pour les longueurs d'ondes comprises entre 900 et 1100 nm, 50% de la lumière incidente est transmise et 50% de la lumière incidente est réfléchie. Pour des longueurs d'ondes supérieures à 1100nm, la lumière est totalement réfléchie.

Le miroir M2 présente des caractéristiques de réflexion telles qu'illustrées sur la Figure 6. En particulier, ce miroir assure la transmission de toutes les longueurs d'onde à l'exception de la longueur d'onde du laser, c'est-à-dire la Iongueur d'onde de 1340nm qui est réfléchie à 100 %.

Dans ce mode de réalisation, lors de la seconde phase d'observation, le faisceau laser incident est focalisé avec une forte puissance sur un point du circuit et le circuit est soumis à une séquence de test. Compte tenu des caractéristiques de réflexion des miroirs M1 et M2, le faisceau laser est totalement réfléchi vers le circuit. Le faisceau réfléchi issu du circuit est lui aussi totalement réfléchi par les miroirs M1 et M2, lesquels sont réfléchissants pour la longueur d'onde du faisceau laser.

En revanche, pour les autres longueurs d'onde émises par le circuit, du fait de la circulation du courant électrique, dû soit à la séquence de test appliquée, soit à l'effet du faisceau laser, la lumière est transmise partiellement au travers du miroir M1 vers le dispositif 22 et est partiellement réfléchie. La lumière réfléchie par le miroir M1 est totalement transmise au travers du miroir M2 jusqu'au détecteur 34.

Ainsi, la lumière émise par le circuit en dehors de la longueur d'onde du laser est transmise pour moitié jusqu'au dispositif 22 et pour moitié jusqu'au détecteur 34.

Ainsi, simultanément, une première image est acquise depuis le dispositif 22 et une deuxième mesure est effectuée en un point donné du circuit par le détecteur 34.

Suivant encore une autre variante, la source laser 26 est remplacée par une source double formée d'une source de lumière blanche ou infrarouge et d'une source laser.

La transmission de la lumière émise par le circuit et du faisceau laser incident au travers du même objectif d'observation 18 et plus généralement au travers de la même chaîne optique permet une excitation du circuit au coeur même de celui-ci alors qu'il est en fonctionnement, ce qui permet de bénéficier simultanément d'une observation du circuit alors qu'il est soumis au rayonnement laser en certains points bien particuliers modifiant ainsi ses conditions de fonctionnement.

## Revendications

1. Dispositif (10) d'analyse d'un circuit (14) comportant :
- au moins un moyen (22 ; 34) d'observation de la lumière émise par au moins une zone d'observation localisée du circuit du fait de la circulation du courant électrique dans cette zone, lequel moyen (22, 34) d'observation de la lumière émise comporte au moins un objectif (18) au travers duquel la lumière émise est transmise,
- des moyens (26) d'excitation du circuit,
les moyens d'excitation du circuit comportant une source laser (26) et des moyens (30) d'application d'un faisceau laser engendré par la source (26), au travers du même objectif (18), au travers duquel la lumière émise est transmise sur une zone d'excitation du circuit simultanément à l'observation du circuit par les moyens d'observation (22 ; 34),
**caractérisé en ce que** le dispositif comporte des moyens (M1, M2) de protection des moyens d'observation (22 ; 34) contre les faisceaux laser incidents et réfléchis par le circuit, les moyens (M1, M2) de protection des moyens d'observation (22 ; 34) comprenant un miroir dichroïque (M1, M2) complètement réfléchissant pour la ou chaque longueur d'onde des faisceaux laser incidents et réfléchis par le circuit, et au moins partiellement transparent pour les autres.

2. Dispositif selon la revendication 1, **caractérisé en ce que** les moyens d'observation (22, 34) et les moyens (30) d'application du faisceau laser comportent des moyens (18, 30) de guidage de la lumière émise par le circuit et des faisceaux laser émis et réfléchis suivant un même chemin optique au voisinage du circuit.

3. Dispositif selon la revendication 1 ou 2, **caractérisé en ce que** les moyens d'observation comportent une matrice de capteurs (22).

4. Dispositif selon la revendication 3, **caractérisé en ce que** les capteurs sont choisis dans le groupe consistant en des capteurs d'imagerie visible ou infrarouge à couplage de charge (CCD), des capteurs à Arséniure de Gallium (InGaAs) ou des capteurs à Tellure de Mercure et Cadmium (MCT).

5. Dispositif selon la revendication 3, **caractérisé en ce que** les capteurs sont des capteurs à émission de lumière tridimensionnelle de type Analyse de Circuit par Imagerie Picoseconde (PICA).

6. Dispositif selon l'une quelconque des revendications précédentes, **caractérisé en ce que** les moyens d'observation comportent un capteur monopoint de lumière en émission résolue dans le temps (34) dit de type TRE (Time Resolved Emission) ou de type PICA monopoint (Single point PICA).

7. Dispositif selon la revendication 2, **caractérisé en ce que** les moyens de guidage de la lumière comportent au moins un miroir semi-réfléchissant (M1, M2) disposé entre le circuit (14) et les moyens d'observation (22 ; 34) suivant un chemin de transmission et entre la source laser (26) et le circuit (14) suivant un chemin de réflexion, le miroir semi-réfléchissant (M1, M2) étant au moins partiellement transparent aux longueurs d'ondes émises par le circuit et réfléchissant pour la longueur d'onde du faisceau laser émis par la source laser (26).

8. Dispositif selon la revendication 7, **caractérisé en ce que** les moyens d'observation de la lumière émise comportent au moins un premier et un deuxième capteurs (22, 34), disposés respectivement en arrière d'un premier et d'un second miroirs semi-réfléchissants (M1, M2), et successivement dans cet ordre du circuit (14) jusqu'à la source laser (26) suivant le trajet du faisceau laser réfléchi, les premier et second miroirs semi-réfléchissants (M1, M2) étant au moins partiellement transparents aux longueurs d'ondes émises par le circuit et réfléchissants pour la longueur d'onde du faisceau laser émis par la source laser (26), le premier miroir semi-réfléchissant (M1) étant seulement partiellement transparent aux longueurs d'ondes d'observation du deuxième capteur (34).

9. Dispositif selon l'une quelconque des revendications précédentes, **caractérisé en ce qu'**il comporte une diode (28) de mesure de l'intensité du faisceau laser réfléchi.

## Patentansprüche

1. Vorrichtung (10) zur Analyse eines Schaltkreises (14), umfassend:
- mindestens ein Mittel (22; 34) zum Beobachten des Lichts, das von mindestens einer lokalisierten Beobachtungszone des Schaltkreises aufgrund der Zirkulation des elektrischen Stroms in dieser Zone emittiert wird, wobei das Mittel (22, 34) zum Beobachten des emittierten Lichts mindestens ein Objektiv (18) umfasst, durch welches das emittierte Licht übertragen wird,
- Mittel (26) zum Erregen des Schaltkreises,
wobei die Mittel zum Erregen des Schaltkreises eine Laserquelle (26) und Mittel (30) zum Aufbringen eines von der Quelle (26) erzeugten Laserstrahls umfassen, durch das gleiche Objektiv (18), durch welches das emittierte Licht auf eine Erregungszone des Schaltkreises übertragen wird, zeitgleich mit der Beobachtung des Schaltkreises durch die Mittel (22; 34) zum Beobachten,
**dadurch gekennzeichnet, dass** die Vorrichtung Mittel (M1, M2) zum Schützen der Mittel (22; 34) zum Beobachten vor einfallenden und von dem Schaltkreis reflektierten Laserstrahlen umfasst, wobei die Mittel (M1, M2) zum Schützen der Mittel (22; 34) zum Beobachten einen dichroitischen Spiegel (M1, M2) beinhalten, der vollständig reflektierend ist für die oder jede Wellenlänge der einfallenden und von dem Schaltkreis reflektierten Laserstrahlen und mindestens teilweise durchlässig für die Übrigen.

2. Vorrichtung nach Anspruch 1, **dadurch gekennzeichnet, dass** die Mittel zum Beobachten (22, 34) und die Mittel (30) zum Aufbringen des Laserstrahls Mittel (18, 30) zum Führen des von dem Schaltkreis emittierten Lichts und der emittierten und reflektierten Laserstrahlen gemäß einem optischen Pfad in der Nähe des Schaltkreises umfassen.

3. Vorrichtung nach Anspruch 1 oder 2, **dadurch gekennzeichnet, dass** die Mittel zum Beobachten eine Sensormatrix (22) umfassen.

4. Vorrichtung nach Anspruch 3, **dadurch gekennzeichnet, dass** die Sensoren gewählt werden aus der Gruppe bestehend aus bildgebenden Sensoren für sichtbares Licht oder Infrarotstrahlung mit Ladungskopplung (CCD), Indium-Gallium-Arsenid-Sensoren (InGaAs) oder Quecksilber-Cadmium-Tellurid-Sensoren (MCT).

5. Vorrichtung nach Anspruch 3, **dadurch gekennzeichnet, dass** die Sensoren Sensoren mit dreidimensionaler Lichtemission vom Typ Schaltkreisanalyse mittels Pikosekunden-Bildgebung (PICA) sind.

6. Vorrichtung nach einem der vorstehenden Ansprüche, **dadurch gekennzeichnet, dass** die Mittel zum Beobachten einen Einzelpunktsensor für Licht in zeitaufgelöster Emission (34) vom so genannten Typ TRE (Time Resolved Emission) oder dem Typ Einzelpunkt-PICA (Single Point PICA) umfassen.

7. Vorrichtung nach Anspruch 2, **dadurch gekennzeichnet, dass** die Mittel zum Führen des Lichts mindestens einen halbreflektierenden Spiegel (M1, M2) umfassen, der zwischen dem Schaltkreis (14) und den Mitteln zum Beobachten (22; 34) gemäß einem Übertragungspfad und zwischen der Laserquelle (26) und dem Schaltkreis (14) gemäß einem Reflexionspfad angeordnet ist, wobei der halbreflektierende Spiegel (M1, M2) für Wellenlängen, die von dem Schaltkreis emittiert werden, mindestens teilweise durchlässig ist und für die Wellenlänge des Laserstrahls, der von der Laserquelle (26) emittiert wird, reflektierend ist.

8. Vorrichtung nach Anspruch 7, **dadurch gekennzeichnet, dass** die Mittel zum Beobachten des emittierten Lichts mindestens einen ersten und einen zweiten Sensor (22, 34) umfassen, die jeweils hinter einem ersten und einem zweiten halbreflektierenden Spiegel (M1, M2) und nacheinander in dieser Reihenfolge des Schaltkreises (14) bis zur Laserquelle (26) gemäß der Strecke des reflektierten Laserstrahls angeordnet sind, wobei der erste und zweite halbreflektierende Spiegel (M1, M2) für Wellenlängen, die von dem Schaltkreis emittiert werden, mindestens teilweise durchlässig sind und für die Wellenlänge des Laserstrahls, der von der Laserquelle (26) emittiert wird, reflektierend sind, wobei der erste halbreflektierende Spiegel (M1) nur für Wellenlängen zum Beobachten des zweiten Sensors (34) teilweise durchlässig ist.

9. Vorrichtung nach einem der vorstehenden Ansprüche, **dadurch gekennzeichnet, dass** sie eine Diode (28) zum Messen der Stärke des reflektierten Laserstrahls umfasst.

## Claims

1. A device (10) for analyzing a circuit (14) including:
- at least one means (22, 34) for observing the light emitted by at least one localized observation area of the circuit because of the circulation of the electric current in this area, which means (22, 34) for observing the emitted light includes at least one objective (18) throughout which the emitted light is transmitted,
- means (26) for exciting the circuit,
the circuit excitation means including a laser source (26) and means (30) for applying a laser beam generated by the source (26), throughout the same objective (18), throughout which the emitted light is transmitted onto an excitation area of the circuit simultaneously with the observation of the circuit by the observation means (22, 34),
**characterized in that** the device includes means (M1, M2) for protecting the observation means (22, 34) against the laser beams, whether incident or reflected by the circuit, the means (M1, M2) for protecting the observation means (22, 34) including a dichroic mirror (M1, M2) fully-reflective for the or each wavelength of the laser beams, whether incident or reflected by the circuit, and at least partially transparent for the other ones.

2. The device according to claim 1, **characterized in that** the observation means (22, 34) and the means (30) for applying the laser beam include means (18, 30) for guiding the light emitted by the circuit and the laser beams emitted and reflected along the same optical path in the vicinity of the circuit.

3. The device according to claim 1 or 2, **characterized in that** the observation means include a sensors matrix (22).

4. The device according to claim 3, **characterized in that** the sensors are selected from charge-coupled (CCD) visible or infrared image sensors, Gallium-Arsenide (InGaAs) sensors or Mercury-Cadmium Telluride (MCT) sensors.

5. The device according to claim 3, **characterized in that** the sensors consist of Picosecond Imaging Circuit Analysis (PICA) type three-dimensional light emission sensors.

6. The device according to any one of the preceding claims, **characterized in that** the observation means include a TRE (Time Resolved Emission) type or single-point PICA type single-point light sensor (34).

7. The device according to claim 2, **characterized in that** the means for guiding the light include at least one semi-reflective mirror (M1, M2) disposed between the circuit (14) and the observation means (22, 34) along a transmission path and between the laser source (26) and the circuit (14) along a reflection path, the semi-reflective mirror (M1, M2) being at least partially transparent to the wavelengths emitted by the circuit and reflective for the wavelength of the laser beam emitted by the laser source (26).

8. The device according to claim 7, **characterized in that** the means for observing the emitted light include at least one first and one second sensors (22, 34), disposed respectively behind first and second semi-reflective mirrors (M1, M2), and successively, **in that** order from the circuit (14) up to the laser source (26) along the pathway of the reflected laser beam, the first and second semi-reflective mirrors (M1, M2) being at least partially transparent to the wavelengths emitted by the circuit and reflective for the wavelength of the laser beam emitted by the laser source (26), the first semi-reflective mirror (M1) being only partially transparent to the observation wavelengths of the second sensor (34).

9. The device according to any one of the preceding claims, **characterized in that** it includes a diode (28) for measuring the intensity of the reflected laser beam.
